# FASCICULE DE BREVET EUROPEEN

(11) **EP 0 969 512 B1**
(45) Date de publication et mention de la délivrance du brevet: **13.05.2009**
(21) Numéro de dépôt: 98112052.0
(22) Date de dépôt: 30.06.1998
(51) Int. Cl.: H01L 27/02, H01L 27/06

(54) **Capteur inductif**
Induktiver Sensor
Inductive sensor

(43) Date de publication de la demande: 05.01.2000
(73) Titulaire: ASULAB S.A., CH-2501 Bienne (CH)
(72) Inventeur: Passeraub, Philippe, 1022 Chavannes-près-Renens (CH)
(74) Mandataire: Surmely, Gérard

(56) Documents cités:
- PATENT ABSTRACTS OF JAPAN vol. 096, no. 008, 30 août 1996 -& JP 08 088324 A (MATSUSHITA ELECTRIC IND CO LTD), 2 avril 1996
- PATENT ABSTRACTS OF JAPAN vol. 010, no. 020 (E-376), 25 janvier 1986 -& JP 60 182175 A (MATSUSHITA DENSHI KOGYO KK), 17 septembre 1985

## Description

La présente invention se rapporte d'une façon générale à une microstructure comprenant un circuit intégré dans un substrat à une face inférieure ou supérieure duquel est agencée une bobine plane, notamment une bobine en spirale déposée galvaniquement sur une couche de passivation prévue en surface de ce substrat. Plus particulièrement, l'invention concerne un capteur inductif selon la revendication 1.

Le document JP 08088324 montre un dispositif comprenant une bobine et un transistor à effet de champ (FET) qui sont disposés de manière à ce que le champ magnétique engendré par la bobine soit perpendiculaire à la direction source-drain du FET et une force de Lorentz agit sur les électrons dans le canal pour confiner les électrons dans le canal et ainsi éliminer un effet canal court.

Dans le cadre de la présente invention, il a été prévu, afin de réduire au maximum les dimensions de la microstructure développée, de superposer au moins partiellement ladite bobine plane avec ledit circuit électronique susmentionné. Cependant, dans le cadre du développement de cette microstructure aux dimensions réduites, l'inventeur a observé que le champ magnétique engendré par la bobine plane avait une influence sur certains transistors sensibles du circuit électronique intégré sous la surface définie par la bobine plane. En particulier, les transistors sensibles sont ceux qui travaillent avec un courant relativement faible.

Pour répondre à ce problème détecté dans le cadre de la présente invention, l'invention a pour objet un capteur inductif comprenant un circuit électronique intégré dans un substrat semiconducteur et une bobine plane formée par un fil conducteur ou une piste conductrice s'étendant en spirale, cette bobine étant agencée à une face supérieure ou inférieure de ce substrat semiconducteur, ledit circuit électronique comprenant un comparateur ayant en entrée une première connexion à un circuit de référence et une deuxième connexion à ladite bobine, ces première et deuxième connexions étant reliées respectivement à deux électrodes de commande de deux transistors d'entrée formant ce comparateur, ces deux transistors d'entrée étant chacun formés par deux régions définissant respectivement une source et un collecteur entre lesquels un courant est engendré en fonction de l'état électrique du transistor considéré, ce capteur inductif étant **caractérisé en ce qu**'au moins les deux transistors d'entrée sont superposés à la surface définie par ladite bobine plane, et en ce qu'ils sont agencés de manière que ladite source et ledit collecteur de chacun d'eux sont alignés selon une direction sensiblement perpendiculaire à une partie dudit fil conducteur ou de ladite piste conductrice qui est située à proximité du transistor d'entrée considéré.

Grâce à ces caractéristiques, le champ magnétique engendré par la bobine plane est parallèle à l'alignement de la source et du collecteur de chacun des deux transistors d'entrée du comparateur qui présentent une grande sensibilité. Ainsi, les électrons formant les courants électriques circulant dans ces transistors entre leurs sources et leurs collecteurs ne subissant pas de force de Lorentz et, dans le cas de transistors à effet de champ (FET), la profondeur du canal entre la source et le collecteur n'est pas affectée par la présence de la bobine superposée au circuit électronique intégré dans le substrat servant de support à cette bobine.

La présente invention sera décrite ci-après plus en détail à l'aide des figures données à titre d'exemple nullement limitatif, dans lesquels :
- la figure 1 est une vue en plan d'un capteur inductif selon l'invention;
- la figure 2 est une vue en coupe selon la ligne II-II de la figure 1;
- la figure 3 est une vue en coupe similaire à la figure 2 d'une variante préférée de réalisation de l'invention, et
- les figures 4 et 5 sont deux schémas décrivant le circuit électronique d'un capteur inductif formé par un oscillateur à relaxation différentielle.

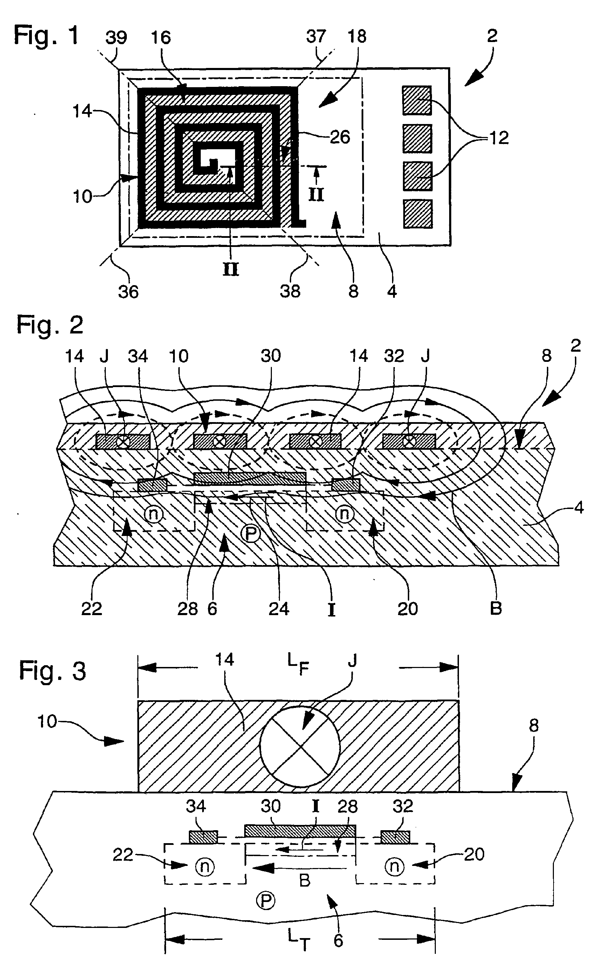

A l'aide des figures 1 et 2, on décrira ci-après un mode de réalisation général d'une microstructure selon l'invention. Le capteur inductif 2 comprend un substrat semiconducteur 4 dans lequel est intégré un circuit électronique formé par une pluralité de transistors 6. A une face supérieure du substrat 4 est agencée une bobine plane 10 et des plages de contact 12. A la figure 2, la bobine 14 est agencée sur la surface supérieure 8 et est recouverte par une couche de passivation ou de protection qui n'a pas été représentée à la figure 1.

La bobine 10 est formée par un fil conducteur ou une piste conductrice 14 qui se développe en spirale. Dans la variante représentée ici, la bobine 10 s'étend donc en spirale sur un seul et même plan. Toutefois, il est possible de prévoir une bobine plane agencée sur plusieurs niveaux séparés par des couches de passivation. La bobine peut être obtenue par divers procédés connus de l'homme du métier, notamment par dépôt d'une couche métallique sous vide, comme dans le cas de la figure 2, ou par un procédé galvanique, comme pour la variante de réalisation représentée à la figure 3.

La bobine 10 définit une surface 16 (surface hachurée de la figure 1). Le circuit électronique formant le capteur 2 est intégré dans le substrat 4 à l'intérieur de la région 18 définie par un trait interrompu. La surface 16 est située à l'intérieur de la région 18, en superposition selon une vue en plan de dessus (figure 1). Au moins quelques transistors de la pluralité de transistors formant le circuit électronique du capteur 2 et la surface 16 définie par la bobine 10 sont superposés l'une aux autres. Selon l'invention, il est prévu qu'au moins l'ensemble des transistors (transistor 6 à la figure 2) qui présentent une grande sensibilité en travaillant à courant électrique relativement faible, parmi les transistors superposés à la surface 16, sont agencés de manière que la source 20 et le collecteur 22 de chacun d'eux sont alignés selon une direction 24 correspondant à la direction du courant électrique I engendré dans le transistor 6 entre la source 20 et le collecteur 22 en fonction de l'état électrique du transistor 6. Cette direction est perpendiculaire à la partie 26 du fil conducteur ou de la piste conductrice 14 située à proximité de ce transistor 6.

Le transistor 6 est un transistor à effet de champ (FET) dans lequel un canal 28 d'une profondeur variable est engendré entre la source 20 et le collecteur 22 en fonction de l'état électrique appliqué à l'électrode de commande 30 définissant la grille de ce transistor 6. On remarquera que la source 20 et le collecteur 22 sont associés respectivement à deux électrodes 32 et 34. Selon l'invention, le courant I circulant dans le canal 28 est sensiblement parallèle au champ magnétique B engendré par la bobine 10 au niveau du canal 28. Ainsi, il n'y a quasi aucune force de Lorentz sur les électrons qui se déplacent entre la source et le collecteur du transistor.

On remarquera à la figure 1 que la bobine est enroulée en spirale selon des segments rectilignes définissant un profil carré ou rectangulaire à l'enroulement de la bobine. Entre les quatre demi-diagonales 36, 37, 38 et 39, on peut définir quatre régions de la surface 16 dans lesquelles le fil ou la piste métallisée 14 définit un ensemble de segments linéaires parallèles entre eux. Ainsi, dans chacune de ces quatre régions, la direction perpendiculaire à celle du fil ou de la piste 14 est univoque. De préférence, les transistors sensibles du circuit intégré sont superposés chacun à l'une seulement de ces quatre régions, à une certaine distance des demi-diagonales. La direction du champ magnétique B traversant le transistor est donc bien définie et sensiblement perpendiculaire à la direction des segments linéaires du fil ou de la piste 14. On garantit ainsi que le champ magnétique B soit sensiblement parallèle au courant électrique I dans le transistor 6 dont le canal 28 est perpendiculaire à la partie 26 de la bobine 10.

A la figure 3 est représenté une variante de réalisation de l'invention formant un perfectionnement du premier mode décrit ci-avant. Le fil électrique 14 de la bobine 10 est obtenu notamment par un bain galvanique. Ce fil 14 présentant une largeur L_{F} de plusieurs micromètres (µm). La longueur L_{T} du transistor 6 est inférieure à la largeur L_{F} du fil 14. Selon l'invention, il est prévu que chaque transistor 6 de l'ensemble des transistors superposés à la surface 26 définie par la bobine 10 et présentant une grande sensibilité sont agencés de manière que chacun d'eux est situé sous le fil 14. Etant donné que le champ magnétique produit par un seul segment de la bobine 10 est circulaire autour de ce segment, le champ magnétique résultant à proximité de ce segment est sensiblement parallèle à la direction définie par le canal 28 entre la source 20 et le collecteur 22 du transistor 6 situé sous le fil 14.

Aux figures 2 et 3, le courant électrique J circulant dans le fil 14 a été symbolisé par une croix dans un cercle.

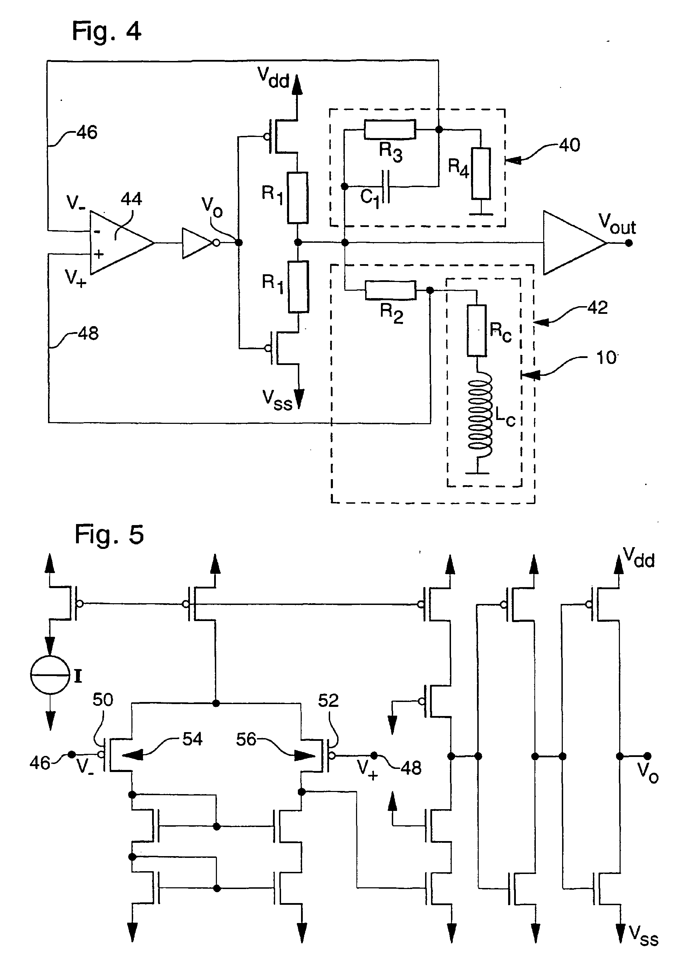

Aux figures 4 et 5 est représenté un schéma électronique correspondant à un mode de réalisation du circuit intégré du capteur 2. La figure 4 représente le schéma électronique général d'un oscillateur à relaxation différentiel comprenant un circuit de référence 40, un circuit de détection 42 comprenant la bobine 10 définie électriquement par une inductance L_{C} et une résistance R_{C}. Un comparateur 44 a en entrée une première connexion 46 au circuit de référence 40 et une deuxième connexion 48 au circuit de détection 42.

A la figure 5 est représenté plus en détail le circuit électronique formant le comparateur 44, lequel présente des miroirs de courant en cascade et des étages d'amplification en cascade. Les connexions 46 et 48 sont reliées respectivement à deux électrodes de commande 50 et 52 de deux transistors d'entrée 54 et 56. Ces deux transistors d'entrée 54 et 56 sont particulièrement sensibles en travaillant avec des courants électriques relativement faibles. Selon l'invention, au moins ces deux transistors 54 et 56 sont agencés de manière que la direction du courant électrique circulant dans le canal entre la source et le collecteur de ces transistors est perpendiculaire à la direction du fil de la bobine situé à proximité de ces transistors. De préférence, ces deux transistors 54 et 56 sont agencés selon la variante préférée de la figure 3.

Lors de l'établissement du plan du circuit intégré, l'homme du métier peut également agencer d'autres transistors représentés à la figure 5 de manière similaire aux transistors d'entrée 54 et 56, c'est-à-dire selon une orientation définie par la présente invention.

## Revendications

1. Capteur inductif (2) comprenant un circuit électronique intégré dans un substrat semiconducteur (4) et une bobine plane (10) formée par un fil conducteur (14) ou une piste conductrice (14) s'étendant en spirale, cette bobine étant agencée à une face supérieure (8) ou inférieure de ce substrat semiconducteur, ledit circuit électronique comprenant un comparateur (44) ayant en entrée une première connexion (46) à un circuit de référence (40) et une deuxième connexion (48) à ladite bobine (10), ces première et deuxième connexions étant reliées respectivement à deux électrodes de commande (50, 52) de deux transistors d'entrée (54, 56) du comparateur, ces deux transistors d'entrée étant chacun formés par deux régions définissant respectivement une source (20) et un collecteur (22) entre lesquels un courant (I) est engendré en fonction de l'état électrique du transistor considéré, ce capteur inductif étant **caractérisé en ce qu'**au moins les deux transistors d'entrée sont superposés à la surface (16) définie par ladite bobine plane (10), et **en ce qu'**ils sont agencés de manière que ladite source et ledit collecteur de chacun d'eux sont alignés selon une direction sensiblement perpendiculaire à une partie dudit fil conducteur ou de ladite piste conductrice qui est située à proximité du transistor d'entrée considéré, de façon à ce que le champ magnétique (B) engendré par la bobine plane (10) soit sensiblement parallèle à la direction d'alignement de la source (20) et du collecteur (22) du transistor d'entrée condidéré.

2. Capteur selon la revendication 1, **caractérisée en ce que** lesdits transistors d'entrée sont constitués par des transistors à effet de champ.

3. Capteur selon la revendication 1 ou 2, précédentes, **caractérisée en ce** chaque transistor d'entrée est agencé sensiblement sous une partie dudit fil (14) ou de ladite piste de ladite bobine (10).

## Claims

1. Inductive sensor (2) including an electronic circuit integrated in a semiconductor substrate (4) and a flat coil (10) formed by a conductive wire (14) or a conductive path (14) extending in a spiral, this coil being arranged on an upper (8) or lower face of said semiconductor substrate, said electronic circuit including a comparator (44) having at its inputs a first connection (46) to a reference circuit (40) and a second connection (48) to said coil (10), these first and second connections being respectively connected to two control electrodes (50, 52) of two input transistors (54, 56) of said comparator, each of these two input transistors being formed by two regions defining respectively a source (20) and a collector (22) between which a current (I) is generated as a function of the electric state of the transistor, this inductive sensor being **characterised in that** at least the two input transistors and the surface (26) defined by said flat coil (10) are superposed, and **in that** they are arranged so that said source and said collector of each of them are aligned along a direction approximately perpendicular to a portion of said conductive wire or said conductive path situated in proximity to the respective input transistor so that the magnetic field (B) generated by said flat coil (10) is substantially parallel to the direction defined by the source (20) and the collector (22) of this respective input transistor.

2. Sensor according to claim 1, **characterised in that** said input transistors are formed by field effect transistors (FET).

3. Sensor according to claim 1 or 2, **characterised in that** each input transistor is substantially arranged under a portion of said wire (14) or said path of said coil (10).

## Patentansprüche

1. Induktiver Sensor (2), der eine in ein Halbleitersubstrat (4) integrierte elektronische Schaltung und eine ebene Spule (10), die aus einem Leiterdraht (14) oder einer Leiterbahn (14) gebildet ist, die spiralförmig verläuft, umfasst, wobei diese Spule an einer oberen Fläche (8) oder einer unteren Fläche dieses Halbleitersubstrats angeordnet ist, wobei die elektronische Schaltung einen Komparator (44) umfasst, der als Eingang eine erste Verbindung (46) mit einer Referenzschaltung (40) und eine zweite Verbindung (48) mit der Spule (10) besitzt, wobei diese erste und diese zweite Verbindung mit zwei entsprechenden Steuerelektroden (50, 52) von zwei Eingangstransistoren (54, 56) des Komparators verbunden sind, wobei diese zwei Eingangstransistoren jeweils durch zwei Bereiche gebildet sind, die eine Source (20) bzw. einen Kollektor (22) definieren, zwischen denen in Abhängigkeit vom elektrischen Zustand des betreffenden Transistors ein Strom (I) erzeugt wird, wobei dieser induktive Sensor **dadurch gekennzeichnet ist, dass** wenigstens die zwei Eingangstransistoren der Oberfläche (16), die durch die ebene Spule (10) definiert ist, überlagert sind und dass diese in der Weise angeordnet sind, dass die Source und der Kollektor jedes von ihnen auf eine Richtung ausgerichtet sind, die zu einem Teil des Leiterdrahts oder der Leiterbahn, der sich in der Nähe des betrachteten Eingangstransistors befindet, senkrecht ist, derart, dass das Magnetfeld (B), das durch die ebene Spule (10) erzeugt wird, zu der Ausrichtung der Source (20) und des Kollektors (22) des betrachteten Eingangstransistors im Wesentlichen parallel ist.

2. Sensor nach Anspruch 1, **dadurch gekennzeichnet, dass** die Eingangstransistoren durch Feldeffekttransistoren gebildet sind.

3. Sensor nach den vorhergehenden Ansprüchen 1 oder 2, **dadurch gekennzeichnet, dass** jeder Eingangstransistor im Wesentlichen unter einem Teil des Drahts (14) oder der Bahn der Spule (10) angeordnet ist.
